# EUROPÄISCHE PATENTSCHRIFT

(11) **EP 2 011 168 B1**
(45) Veröffentlichungstag und Bekanntmachung des Hinweises auf die Patenterteilung: **05.08.2009**
(21) Anmeldenummer: 07728180.6
(22) Anmeldetag: 17.04.2007
(51) Int. Cl.: H01L 41/047, H01L 41/083, H01L 41/24

(54) **PIEZOAKTOR MIT AUßEN KONTAKTIERTEN INNENELEKTRODEN EINES PIEZOELEMENTS**
PIEZO ACTUATOR COMPRISING EXTERNALLY CONTACTED INNER ELECTRODES OF A PIEZO ELEMENT
ACTIONNEUR PIÉZOÉLECTRIQUE DOTÉ D'ÉLECTRODES INTERNES À CONTACT EXTERNE D'UN ÉLÉMENT PIÉZOÉLECTRIQUE

(30) Priorität: 19.04.2006 DE 102006018035
(43) Veröffentlichungstag der Anmeldung: 07.01.2009
(73) Patentinhaber: Robert Bosch GmbH, 70442 Stuttgart (DE)
(72) Erfinder: HOHMANN, Eugen, 96191 Viereth-Trunstadt (DE); FERGEN, Immanuel, 76646 Bruchsal (DE)
(86) Internationale Anmeldenummer: PCT/EP2007/053715
(87) Internationale Veröffentlichungsnummer: WO 2007/118878

(56) Entgegenhaltungen:
- EP-A2- 1 204 152
- WO-A-20/04114424
- WO-A-20/05074050
- DE-A1- 3 330 538
- DE-A1- 10 259 949

## Beschreibung

Die Erfindung betrifft einen Piezoaktor, beispielsweise zur Betätigung eines mechanischen Bauteils wie ein Ventil oder dergleichen, mit außen kontaktierten Innenelektroden eines Piezoelements nach den gattungsgemäßen Merkmalen der nebengeordneten Hauptansprüche.

### Stand der Technik

Es ist an sich bekannt, dass zum Aufbau des zuvor erwähnten Piezoaktors ein Piezoelement so eingesetzt werden kann, dass unter Ausnutzung des piezoelektrischen Effekts eine Steuerung des Nadelhubes eines Ventils oder dergleichen vorgenommen werden kann. Das Piezoelement ist aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und von der Höhe und Polarität der elektrischen Spannung einen Druck oder Zug des Piezoelements zur Folge hat. Derartige Piezoaktoren eignen sich somit für Anwendungen, bei denen Hubbewegungen unter hohen Betätigungskräften und/oder hohen Taktfrequenzen ablaufen.

Beispielsweise ist ein solcher Piezoaktor als Bestandteil eines Piezoinjektors aus der DE 10026005 A1 bekannt, der zur Ansteuerung der Düsennadel bei Injektoren zur Einspritzung von Kraftstoff in den Brennraum eines Verbrennungsmotors verwendet werden kann. Bei diesem Piezoaktor ist ein Piezoelement als Stapel mehrerer elektrisch miteinander gekoppelter piezokeramischer Schichten aufgebaut, der unter Vorspannung zwischen zwei Anschlägen gehalten ist. Jede piezokeramische Schicht ist als Piezolage zwischen zwei Innenelektroden eingefasst, über die von außen eine elektrische Spannung angelegt werden kann. Aufgrund dieser elektrischen Spannung führen die piezokeramischen Schichten dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei dem zuvor erwähnten Piezoaktor wird zur Heranführung der un-Lerschiedlichen Potenziale eine wechselseitige seitliche Kontaktierung der Innenelektroden über äußere Elektroden vorgenommen, bei der leitende Flächen auf jeweils einer Seitenfläche des Piezoelements angebracht sind, die mit den jeweiligen Innenelektroden kontaktiert sind.

Bei einer Betätigung des Piezoaktors treten unterschiedliche mechanische Kräfte im Bereich der Innenelektroden sowie im Bereich der Kontaktierungen an den Außenelektroden auf, die zu mechanischen Spannungen und dadurch zu Rissen in den Außenelektroden führen können. Die Außenelektroden müssen dann wiederum mit Anschlusselektroden versehen werden, die weiter nach außen geführt werden und in der Regel auch mechanischen Spannungen standhalten müssen.

In der DE 19928190 A1 ist ein Piezoaktor beschrieben, bei dem zur Erreichung einer gewissen Flexibilität mindestens eine Schicht der jeweilige Außenelektrode netz-, sieb- oder gewebear-Lig auf jeweils einer Seitenfläche verteilt aufgebaut und zumindest punktweise mit den jeweiligen Innenelektroden kontaktiert ist. Darüber hinaus ist auch aus der DE 1998178 A1 bekannt, dass ein solcher Piezoaktor mit Metallfolien als Bestandteil der Außenelektroden versehen werden kann, die jeweils zumindest im Bereich von neutralen Schichten im Aufbau des Piezoelements Ausgleichswellen aufweisen.

Die Außenkontaktierung kann bei den bekannten Piezoaktoren beispielsweise mit einem beschichteten Sieb doppellagig ausgeführt werden und während der Anbindung mittels eines Lötprozesses werden alle Webknoten des Siebes fest verklammert und mit Lot angebunden. Die zuvor erwähnte gewünschte Beweglichkeit des Siebgewebes wird dabei in der Regel jedoch stark reduziert und kann nur eingeschränkt genutzt werden.

### Offenbarung der Erfindung

Die Erfindung geht von einem eingangs beschriebenen Piezoaktor aus, der mit einem Mehrschichtaufbau von Piezolagen in einem Piezoelement und zwischen den Piezolagen angeordneten Innenelektroden versehen ist. Die Innenelektroden sind in Richtung des Lagenaufbaus des Piezoelements abwechselnd mit einer unterschiedlichen Polarität einer elektrischen Spannung über eine wechselseitige seitliche Kontaktierung beaufschlagt, wobei die Kontaktierung mittels Außenelektroden erfolgt, die einen netz-, sieb- oder gewebeartigen Werkstoff aufweisen. Erfindungsgemäß ist dieser Werkstoff in vorteilhafter Weise ein Mischgewebe mit einem elektrisch leitfähigen Anteil, das mit einem flexiblen leitenden Bindemittel zur Kontaktierung der Innenelektroden an das Piezoelement bzw. an den Piezoaktor angebunden ist.

Mit einer solchen erfindungsgemäßen Kontaktierung kann auf einfache Weise eine duktile Anbindung der Innenelektroden geschaffen werden, die gut leitend ist, eine hohe mechanische Ausdehnung gestattet und eine Temperaturbeständigkeit bis zu 200 °C gewährleisten kann.

Bei einer bevorzugten Ausführungsform kann das Mischgewebe ein leitendes Mikro-Textilgewebe sein, das beispielsweise aus mit einem leitenden Material beschichteten Polyesterfasern hergestellt ist. Als Basis können hierbei neben Polyester aber auch Fasern aus beispielsweise Aramid, Kevlar, Carbon, PPS oder PP dienen.

Andererseits kann das Mischgewebe auch aus mit solchen Fasern verwebten Metalldrähten oder -fasern bestehen, die aus Zink-, Kupfer-, Silber- oder Goldlegierungen gebildet werden können. Hierbei sind beispielsweise Monofilamente aus Cu, Ag, Au, Invar, Bronze oder Messing verwendbar und es sind hier auch Legierungen zum Beispiel aus Fe, Cr, Ni, Mo anwendbar.

Das zuvor beschriebene Mischgewebe kann dann mittels eines leitenden Harzes an das Piezoelement angebunden werden, zum Beispiel mittels eines Polymers oder eines leitenden Harzes.

Die notwendige nach außen geführte elektrische Kontaktierung des Mischgewebes kann dann auf einfache Weise mittels einer Quetschverbindung oder mittels Klebens eines entsprechenden Anschlusskontaktes durchgeführt werden.

Bei einem vorteilhaften Verfahren zur Herstellung eines zuvor beschriebenen Piezoaktors wird das Piezoelement nach einem Sinterprozess an den Seiten geschliffen und es erfolgt ein Heißpolen. Dann wird das Aufkleben des Mischgewebes und nach einem Aushärten der Klebeverbindung eine abschließende Tauchlackierung des Piezoaktors vorgenommen.

Zusammenfassend gesehen kann mit dem erfindungsgemäßen Piezoaktor somit vor allem eine sichere und dauerhafte Außenkontaktierung der Innenelektroden des Piezoelementes erreicht werden. Die durch die Betätigung des Piezoaktors bewirkten Bewegungen innerhalb des Piezoelements führen zu unterschiedlichen Bewegungen in drei Achsen. In der Hauptbewegungs- bzw. Betätigungsrichtung (Z-Achse) dehnt sich ein solcher Piezoaktor beispielsweise um ca. 100-120 µm aus; in der X- und Y-Achse zieht er sich dagegen um ca. 40-50 µm zusammen.

Aus diesem Grund wird zum Beispiel beim eingangs erwähnten Stand der Technik die Außenkontaktierung mit einem beschichteten doppellagigen Sieb ausgeführt. Die elektrische Anbindung wird dann beim Stand der Technik mittels eines Lötprozesses vorgenommen, bei dem alle Webknoten des Siebes fest verklammert und unter Einschränkung der Beweglichkeit mit Lot abgebunden werden.

Mit den erfindungsgemäßen Ausführungsformen wird eine kostengünstig herstellbare Außenanbindung der Innenelektroden geschaffen, die den zuvor beschriebenen Bewegungsanforderungen bzw. dem geforderten Dehnungsvermögen in den drei Achsrichtungen, beispielsweise während einer Laufzeit von bei vielen Anwendungsfällen getätigten 10⁹ Lastspielen, des Piezoaktors erfüllen. Der bisher notwendige Arbeitsgang des Lötens entfällt komplett, da die Anbindung der Außenkontakte auf einfache Weise durch eine kostengünstige Klebeverbindung erfolgen kann. Auch kann in der Regel auf eine sonst gebräuchliche Grundmetallisierung der Seitenflächen des Piezoaktors ohne Nachteile verzichtet werden.

### Kurze Beschreibung der Zeichnungen

Ein Ausführungsbeispiel des erfindungsgemäßen Piezoaktors wird anhand der Zeichnung erläutert. Es zeigen:
- Figur 1: einen Schnitt durch einen Piezoaktor mit einem Mehrschichtaufbau von Piezolagen und Innenelektroden sowie einer siebartigen Außenelektrode nach dem Stand der Technik,
- Figur 2: eine Detailansicht eines Ausschnitts einer Seitenfläche eines Piezoaktors mit einer schematisch angedeuteten erfindungsgemäßen Außenkontaktierung,
- Figur 3: eine Ansicht eines Mischgewebes als Außenkontaktierung und
- Figur 4: einen schematischen Schnitt durch die Fasern des Mischgewebes nach der Figur 3.

### Ausführungsformen der Erfindung

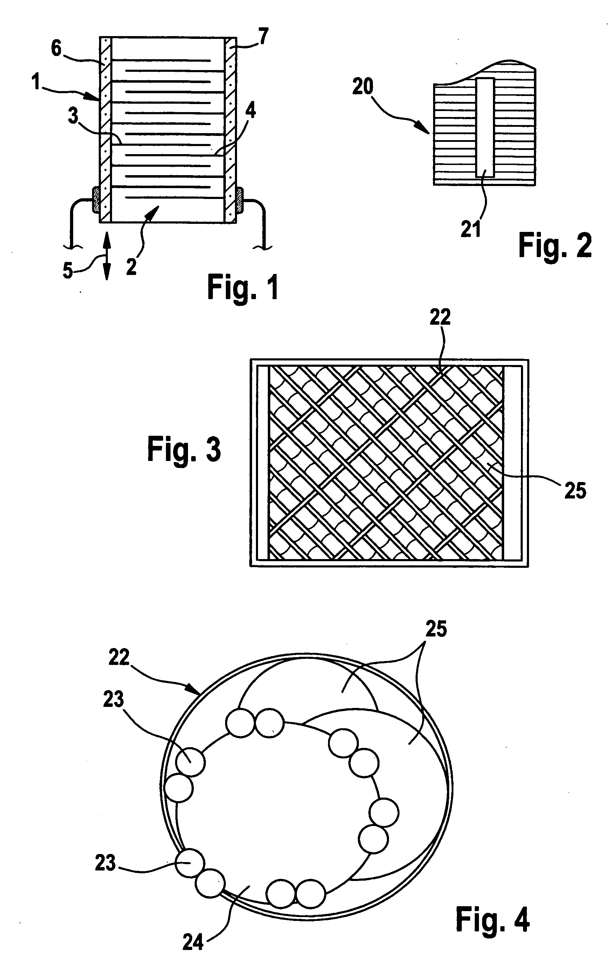

In Figur 1 ist ein beispielsweise aus dem eingangs erwähnten SLand der Technik DE 19928190 A1 bekannter Piezoaktor 1 gezeigt, der ein Piezoelement 2 aus Piezolagen oder -folien aufweist, die unter Ausnutzung des Piezoeffekts bei Anlage einer elektrischen Spannung an Innenelektroden 3 und 4 eine mechanische Reaktion des Piezoaktors 1 in axialer Richtung (Pfeil 5) erfolgt.

Die Innenelektroden 3 und 4 sind dabei in Richtung des Lagenaufbaus des Piezoelements 2 abwechselnd mit einer unterschiedlichen Polarität einer elektrischen Spannung beaufschlagt. Dies wird durch eine wechselseitige seitliche Kontaktierung der Innenelektroden 3 und 4 über netz- oder siebartige Außenelektroden 6 und 7 erreicht, über die die elektrische Spannung zuführbar ist, wobei die Außenelektroden 6 und 7 in der Regel mindestens aus einer eingebrannten Grundmetallisierung der Seitenflächen des Piezoaktors 1 bestehen, auf die die netz- oder siebartigen Außenelektroden 6 und 7 bei dem aus dem Stand der Technik bekannten Piezoaktor 1 aufgelötet sind. Der Piezoaktor 1 kann dann über ein hier nicht dargestelltes Fuß- und/oder Kopfteil fest in ein Gehäuse, beispielsweise das Gehäuse eines Einspritzventils für Kraftfahrzeuge zur Steuerung des Ventils, eingebettet werden und damit Bestandteil eines sogenannten Piezoinjektors sein.

In Figur 2 ist ein Teil der Seitenfläche eines erfindungsgemäßen Piezoaktors 20 gezeigt, auf dem schematisch eine Außenelektrode 21 für die Kontaktierung der hier nur angedeuteten Innenelektroden angebracht ist. Die Außenelektrode 21 besteht hier aus einem leitenden Mischgewebe, das mittels eines leitenden Harzes oder eines Polymers auf die Seitenfläche des Piezoaktors 20 geklebt ist und anhand von Figur 3 und 4 erläutert werden soll.

Bei dem in der Figur 3 dargestellten Ausführungsbeispiel ist das Mischgewebe der Außenelektrode 21 ein leitendes Mikro-Textilgewebe 22, das, wie aus der Figur 4 ersichtlich, aus mit einem leitenden Material 23 beschichteten Fasern 24 aus Polyester (PE)gebildet ist. Als Materialbasis für die Faser 24 kann jedoch auch neben Polyester (PE) auch Aramid, Kevlar, Carbon, Polyphenylensulfid (PPS) oder Polypropylen (PP) dienen.

Aus der Figur 4 ist noch ersichtlich, dass das Mischgewebe 22 auch aus mit den Fasern 24 verwebten Metalldrähten oder -fasern 25 gebildet werden kann, die zur Verbesserung der Leitfähigkeit aus Zink-, Kupfer-, Silber- oder Goldlegierungen hergestellt werden können. Das zuvor beschriebene Mischgewebe 22 kann dann beispielsweise mittels eines elektrisch leitenden Harzes oder Polymers an das Piezoelement bzw. den Piezoaktor 20 angebunden werden.

## Patentansprüche

1. Piezoaktor, mit einem Mehrschichtaufbau von Piezolagen in einem Piezoelement (2) und zwischen den Piezolagen angeordneten Innenelektroden (3,4), die in Richtung des Lagenaufbaus des Piezoelements (2) abwechselnd mit einer unterschiedlichen Polarität einer elektrischen Spannung beaufschlagt sind und einer wechselseitigen seitlichen Kontaktierung der Innenelektroden (3,4) über Außenelektroden (6,7), über die die elektrische Spannung zuführbar ist, wobei die Außenelektroden (6,7) einen netz-, sieb- oder gewebeartigen Werkstoff aufweisen, **dadurch gekennzeichnet, dass** der netz-, sieb- oder gewebeartige Werkstoff ein Mischgewebe (22) mit einem elektrisch leitfähigen Anteil ist, das mit einem flexiblen, elektrisch leitenden Bindemittel zur Kontaktierung der Innenelektroden (3,4) an das Piezoelement (2) angebunden ist.

2. Piezoaktor nach Anspruch 1, **dadurch gekennzeichnet, dass** das Mischgewebe ein elektrisch leitendes Mikro-Textilgewebe (22) ist.

3. Piezoaktor nach Anspruch 1 oder 2, **dadurch gekennzeichnet, dass** das Mischgewebe (22) aus mit einem leitenden Material (23) beschichteten Polyester- oder sonstigen Kunststofffasern (24) gebildet ist.

4. Piezoaktor nach Anspruch 3, **dadurch gekennzeichnet, dass** das Mischgewebe (22) aus mit den Fasern (24) verwebten Metalldrähten oder Metallfasern (25) besteht.

5. Piezoaktor nach Anspruch 4, **dadurch gekennzeichnet, dass** die mit den Fasern (24) verwebten Metalldrähte oder Metallfasern (25) aus Zink-, Kupfer-, Silber- oder Goldlegierungen bestehen.

6. Piezoaktor nach einem der vorhergehenden Ansprüche, **dadurch gekennzeichnet, dass** das Mischgewebe (22) mittels eines elektrisch leitenden Harzes an den Piezoaktor (20) angebunden ist.

7. Piezoaktor nach einem der Ansprüche 1 bis 5, **dadurch gekennzeichnet, dass** das Mischgewebe (22) mittels eines elektrisch leitenden Polymers an den Piezoaktor (20) angebunden ist.

8. Piezoaktor nach einem der vorhergehenden Ansprüche, **dadurch gekennzeichnet, dass** die nach außen geführte elektrische Kontaktierung des Mischgewebes (22) mittels einer Quetschverbindung oder mittels Klebens durchführbar ist.

9. Verfahren zur Herstellung eines Piezoaktors (20) nach einem der vorhergehenden Ansprüche, **dadurch gekennzeichnet, dass** das Piezoelement (2) des Piezoaktors (20) nach einem Sinterprozess an den Seiten geschliffen wird, dass ein Heißpolen erfolgt, dass ein Aufkleben des Mischgewebes (22) und dass nach einem Aushärten der Klebeverbindung eine abschließende Tauchlackierung des Piezoaktors (20) vorgenommen wird.

## Claims

1. Piezo actuator, with a multilayered structure of piezo layers in a piezo element (2) and inner electrodes (3, 4), which are arranged between the piezo layers and are alternately subjected to an electric voltage of a different polarity in the direction of the layer structure of the piezo element (2), and with alternate lateral contacting of the inner electrodes (3, 4) by way of outer electrodes (6, 7), over which the electric voltage can be supplied, the outer electrodes (6, 7) comprising a net-, sieve- or fabric-like material, **characterized in that** the net-, sieve- or fabric-like material is a mixed fabric (22) with an electrically conductive component, which is connected to the piezo element (2) by means of a flexible, electrically conducting binder for contacting the inner electrodes (3, 4).

2. Piezo actuator according to Claim 1, **characterized in that** the mixed fabric is an electrically conducting micro-textile fabric (22).

3. Piezo actuator according to Claim 1 or 2, **characterized in that** the mixed fabric (22) is formed from polyester or other synthetic fibres (24) coated with a conducting material (23).

4. Piezo actuator according to Claim 3, **characterized in that** the mixed fabric (22) comprises metal wires or metal fibres (25) woven with the fibres (24).

5. Piezo actuator according to Claim 4, **characterized in that** the metal wires or metal fibres (25) woven with the fibres (24) consist of zinc, copper, silver or gold alloys.

6. Piezo actuator according to one of the preceding claims, **characterized in that** the mixed fabric (22) is connected to the piezo actuator (20) by means of an electrically conducting resin.

7. Piezo actuator according to one of Claims 1 to 5, **characterized in that** the mixed fabric (22) is connected to the piezo actuator (20) by means of an electrically conducting polymer.

8. Piezo actuator according to one of the preceding claims, **characterized in that** the outward electrical contacting of the mixed fabric (22) can be carried out by means of a crimped connection or by means of adhesive bonding.

9. Method for producing a piezo actuator (20) according to one of the preceding claims, **characterized in that** the piezo element (2) of the piezo actuator (20) is ground at the sides after a sintering process, **in that** hot polarizing takes place, **in that** adhesive attachment of the mixed fabric (22) is performed and **in that**, after curing of the adhesive bond, final dip coating of the piezo actuator (20) is performed.

## Revendications

1. Piézo-actionneur qui présente :
une structure stratifiée de couches piézoélectriques dans un élément piézoélectrique (2) et des électrodes intérieures (3, 4) disposées entre les couches piézoélectriques et sur lesquelles des tensions électriques de polarités différentes sont appliquées en alternance dans la direction de la structure stratifiée de l'élément piézoélectrique (2) et
une mise en contact latérale alternée des électrodes intérieures (3, 4) par l'intermédiaire d'électrodes extérieures (6, 7) par lesquelles les tensions électriques peuvent être apportées,
les électrodes extérieures (6, 7) présentant un matériau en forme de treillis, de tamis ou de tissu,
**caractérisé en ce que**
le matériau en forme de treillis, de tamis ou de tissu est un tissu mixte (22) qui présente une partie électriquement conductrice reliée à l'élément piézoélectrique (2) par un moyen de liaison flexible électriquement conducteur qui assure le contact avec les électrodes intérieures (3, 4).

2. Piézo-actionneur selon la revendication 1, **caractérisé en ce que** le tissu mixte est un tissu microtextile électriquement conducteur (22).

3. Piézo-actionneur selon les revendications 1 ou 2, **caractérisé en ce que** le tissu mixte (22) est formé de fibres (24) de polyester ou d'une autre matière synthétique revêtues d'un matériau conducteur (23).

4. Piézo-actionneur selon la revendication 3, **caractérisé en ce que** le tissu mixte (22) est constitué de fils métalliques ou de fibres métalliques (25) tissées avec les fibres (24).

5. Piézo-actionneur selon la revendication 4, **caractérisé en ce que** les fils métalliques ou fibres métalliques (25) tissées avec les fibres (24) sont constituées d'alliages de zinc, de cuivre, d'argent ou d'or.

6. Piézo-actionneur selon l'une des revendications précédentes, **caractérisé en ce que** le tissu mixte (22) est relié au piézo-actionneur (20) au moyen d'une résine électriquement conductrice.

7. Piézo-actionneur selon l'une des revendications 1 à 5, **caractérisé en ce que** le tissu mixte (22) est relié au piézo-actionneur (20) au moyen d'un polymère électriquement conducteur.

8. Piézo-actionneur selon l'une des revendications précédentes, **caractérisé en ce que** la mise en contact électrique du tissu mixte (22) prolongé vers l'extérieur peut être réalisée au moyen d'une liaison par écrasement ou au moyen d'un collage.

9. Procédé de fabrication d'un piézo-actionneur (20) selon l'une des revendications précédentes, **caractérisé en ce qu'**après une opération de frittage, l'élément piézoélectrique (2) du piézo-actionneur (20) est meulé sur ses faces de manière à obtenir une polarisation à chaud, **en ce que** l'on colle le tissu mixte (22) et **en ce qu'**après le durcissement de la liaison collée, on réalise par immersion un vernis de finition du piézo-actionneur (20).
